# EUROPÄISCHE PATENTSCHRIFT

(11) **EP 3 913 804 B1**
(45) Veröffentlichungstag und Bekanntmachung des Hinweises auf die Patenterteilung: **22.07.2026**
(21) Anmeldenummer: 21174093.1
(22) Anmeldetag: 17.05.2021
(51) Int. Cl.: H03K 17/082

(54) **ÜBERSPANNUNGSSCHUTZ**
SURGE PROTECTION ELEMENT
PROTECTION CONTRE LES SURTENSIONS

(30) Priorität: 18.05.2020 DE 102020206250
(43) Veröffentlichungstag der Anmeldung: 24.11.2021
(73) Patentinhaber: Ellenberger & Poensgen GmbH, 90518 Altdorf (DE)
(72) Erfinder: GERDINAND, Frank, 38350 Helmstedt (DE); KÖPF, Hendrik-Christian, 90489 Nürnberg (DE); SAFAVI HIR, Masoud, 90461 Nürnberg (DE); STEEGMÜLLER, Peter, 90449 Nürnberg (DE)
(74) Vertreter: FDST Patentanwälte

(56) Entgegenhaltungen:
- WO-A1-2006/100192
- WO-A1-2019/141811
- US-A- 3 534 226
- US-A- 3 641 358
- US-A- 6 075 684

## Beschreibung

Die Erfindung betrifft einen Überspannungsschutz.

Elektrische Geräte weisen üblicherweise eine elektrische Nennspannung auf, bei der diese betrieben werden. Sofern diese Nennspannung signifikant überstiegen wird, ist eine Beschädigung des elektrischen Geräts möglich. Ein Übersteigen der Nennspannung tritt beispielsweise aufgrund eines technischen Defekts des elektrischen Geräts oder eines sonstigen Bestandteils des Stromkreises auf, dessen Bestandteil das elektrische Gerät ist. Zur Absicherung des elektrischen Geräts gegenüber derartigen elektrischen Spannungen werden üblicherweise Sicherungen oder Schutzschalter verwendet.

Ferner ist es erforderlich, dass elektrische Geräte gegen eine Überspannung gesichert werden, die beispielsweise aufgrund eines Blitzschlages in eine Leitung des Stromkreises oder das elektrische Gerät selbst entstehen. Auch ist es möglich, dass innerhalb des Stromkreises aufgrund einer induktiven Kopplung eines Bestandteils des Stromkreises mit einem Blitz eine derartige Überspannung entsteht. Zudem können aufgrund von elektromagnetischen Pulsen (EMP) oder aufgrund elektrostatischer Entladungen (ESD) sowie Schaltvorgängen in dem Stromkreis derartige Überspannungen entstehen, die zu einer Beschädigung des Geräts führen können. Derartige Überspannungen übersteigen in einem vergleichsweise großen Maß die Nennspannung. Auch entstehen die Überspannungen aufgrund externer Ereignisse und sind daher durch das elektrische Gerät nicht beeinflussbar und können deswegen nicht vermieden werden.

Zur Absicherung des elektrischen Geräts gegen Überspannungen wird ein Überspannungsschutz herangezogen, der parallel zu dem zu schützenden Gerät geschaltet wird. Der Überspannungsschutz selbst weist beispielsweise eine Funkenstrecke oder einen Varistor auf. Hierbei wird die Überspannung um das zu schützende Gerät herumgeleitet, wobei beispielsweise ein Lichtbogen erzeugt wird. Die Funkenstrecke und der Varistor unterliegen Alterungseffekten, sodass nach einer bestimmten Zeitdauer die elektrische Spannung variiert, ab der der Überspannungsschutz anspricht. Auch führen auftretende Überspannungen zu einem Verschleiß des Überspannungsschutzes. Infolgedessen ist nicht sichergestellt, dass sämtliche Überspannungen, die zu einer Beschädigung des Geräts führen könnten, stets mittels des Überspannungsschutzes abgefangen werden. Somit muss der Überspannungsschutz nach bestimmten Zeitspannen ausgetauscht werden, um eine bestimmungsgemäße Funktionsweise zu gewährleisten.

In WO 2019/141811 A1 ist eine Klemmschaltung offenbart, die zur Begrenzung einer Überspannung bei einem Wechselstrom eingesetzt werden soll. Es sind zwei zueinander parallelgeschaltete Stränge vorhanden, die zueinander spiegelbildlich aufgebaut sind. Diese werden mittels jeweils einer Signalschaltung betätigt, die wiederum mittels einer Triggerschaltung betätigt sind.

Der Erfindung liegt die Aufgabe zugrunde, einen besonders geeigneten Überspannungsschutz als auch eine besonders geeignete Verwendung eines Überspannungsschutzes anzugeben, wobei insbesondere eine Sicherheit erhöht und vorzugsweise Herstellungs- und/oder Betriebskosten gesenkt sind.

Hinsichtlich des Überspannungsschutzes wird diese Aufgabe durch die Merkmale des Anspruchs 1, hinsichtlich der Verwendung einerseits durch die Merkmale des Anspruchs 7 und andererseits durch die Merkmale des Anspruchs 8 erfindungsgemäß gelöst. Vorteilhafte Weiterbildungen und Ausgestaltungen sind Gegenstand der Unteransprüche.

Der Überspannungsschutz weist einen ersten Anschluss und einen zweiten Anschluss auf. Dabei dient der Überspannungsschutz der Vermeidung einer (elektrischen) Überspannung zwischen dem ersten Anschluss und dem zweiten Anschluss. Hierfür ist der Überspannungsschutz zweckmäßigerweise geeignet, vorgesehen und/oder eingerichtet. Die Überspannung ist beispielsweise eine Wechselspannung oder eine Gleichspannung. Beispielsweise ist der Überspannungsschutz geeignet, insbesondere vorgesehen und eingerichtet, (andere) Bauteile mit einer (elektrischen) Nennspannung vor einer Überspannung zu schützen. Die Nennspannung ist vorzugsweise größer oder gleich 12 V, 24 V, 48 V, 100 V oder 200 V. Beispielsweise ist die maximale Nennspannung 6kV, 5kV, 4,5kV, 4kV, 3kV, 2kV, 1.500 V, 1.200V, 1.100 V, 1.000 V, 900 V oder 800 V.

Der Überspannungsschutz weist eine Anzahl an Strängen auf, die zueinander parallel geschaltet sind. Hierbei befinden sich die Stränge zwischen den beiden Anschlüssen und sind beispielsweise mit diesen elektrisch direkt verbunden. Alternativ hierzu ist zumindest einer der Anschlüsse, beispielsweise beide, über ein zusätzliches Bauteil mit den Strängen elektrisch verbunden. Insbesondere wird als derartiges Bauteil eine oder mehrere Dioden herangezogen. Zweckmäßigerweise ist ein derartiges Bauteil eine B4-Brücke. Infolgedessen ist es möglich, den Überspannungsschutz bidirektional zu betreiben. Insbesondere ist der Überspannungsschutz somit bidirektional ausgestaltet, wobei dies zum Beispiel mittels der B4-Brücke erfolgt. Alternativ hierzu erfolgt die Bereitstellung der Bidirektionalität mittels weiterer Bestandteile. **In** einer Alternative hierzu ist der Überspannungsschutz unidirektional ausgestaltet.

Jeder Strang weist jeweils einen Widerstand auf, der zweckmäßigerweise ein ohmscher Widerstand ist. Der jeweilige Widerstand ist dabei zwischen den ersten Anschluss und ein Schaltelement geschaltet, wobei das Schaltelement ein Bestandteil des jeweiligen Strangs ist. Somit sind genauso viele Widerstände wie Schaltelemente vorhanden, und es sind genauso viele Widerstände und Schaltelemente wie Stränge vorhanden. Hierbei ist jeder Widerstand stets zwischen dem ersten Anschluss und dem jeweils zugeordneten Schaltelement angeordnet, die somit elektrisch in Reihe geschaltet sind. Mittels jedes Schaltelements ist es dabei möglich, einen Stromfluss über den jeweiligen Strang zu unterbrechen. Mit anderen Worten wird bei Ein- oder Ausschalten des Schaltelements der Strang elektrisch geschlossen bzw. aufgetrennt.

Jedes Schaltelement weist einen Steuereingang auf, mittels dessen eine Betätigung des jeweiligen Schaltelements erfolgt. Somit wird insbesondere in Abhängigkeit eines an dem Steuereingang anliegenden elektrischen Potentials der Schaltzustand des jeweiligen Schaltelements verändert. Mittels Betätigung des Schaltelements ist es somit möglich, den jeweiligen Strang elektrisch zu schließen, sodass ein Stromfluss zwischen den beiden Anschlüssen über diesen Strang erfolgt. Infolgedessen wird aufgrund des jeweils zugeordneten Widerstands eine elektrische Spannung begrenzt bzw. ein elektrischer Stromfluss eingestellt.

Aufgrund der Parallelschaltung der einzelnen Stränge ist es daher möglich, die zwischen den beiden Anschlüssen anfallende elektrische Spannung zu begrenzen und somit die Überspannung zwischen den beiden Anschlüssen zu verhindern. Hierbei ist es möglich, mittels Auswahl der jeweiligen Stränge die zwischen den Anschlüssen anliegende elektrische Spannung einzustellen. So erfolgt dann, wenn alle Stränge elektrisch leitfähig sind, was mittels Ansteuerung der jeweiligen Schaltelemente eingestellt wird, eine Aufteilung des Stromflusses über sämtliche Stränge, weswegen die Überspannung zwischen den beiden Anschlüssen verringert ist. Mittels sukzessiven Abschaltens der einzelnen Stränge, also Betätigung der einzelnen Schaltelemente, wird der Stromfluss reduziert und somit insbesondere eine zwischen den Anschlüssen anliegende elektrische Spannung erhöht.

Vorzugsweise werden dabei dann, wenn zwischen den Anschlüssen eine Überspannung anliegt, zunächst sämtliche Schaltelement betätigt, sodass sämtliche Stränge zunächst stromführend sind. Infolgedessen sinkt eine elektrische Spannung zwischen den beiden Anschlüssen ab. Wenn diese geringer als ein bestimmter Wert ist, wird insbesondere zumindest einer der Stränge abgeschaltet, sodass ein Stromfluss auf die verbleibenden Stränge aufgeteilt wird, weswegen eine elektrische Spannung zwischen den beiden Anschlüssen erneut ansteigt, bevorzugt auf einen geringeren Wert als die ursprüngliche Überspannung. Dann, wenn die elektrische Spannung wiederum geeignet abgesunken ist, wird insbesondere ein weiteres der Schaltelemente betätigt und somit die anliegende elektrische Spannung erhöht, wobei der Wert jedoch wieder geringer als die Überspannung ist, die zur Aktivierung des Überspannungsschutzes führte. Dies wird zweckmäßigerweise fortgesetzt, bis sämtliche Schaltelemente geöffnet sind.

Der Überspannungsschutz weist ferner einen Spannungsteiler auf, der eine zu der Anzahl an Strängen korrespondierende Anzahl an elektrisch in Reihe geschalteten Widerstandselementen aufweist. Insbesondere ist die Anzahl der Widerstandselemente gleich der Anzahl der Stränge oder steht in einer festen Beziehung zu dieser. Insbesondere ist hierbei die Anzahl der Widerstandselemente um einen bestimmten Wert größer oder kleiner als die Anzahl an Strängen, insbesondere jeweils um 1. Zwischen jeweils benachbarten Widerstandselementen ist dabei jeweils ein Abgriff gebildet, und der Spannungsteiler weist somit einen Abgriff weniger als Widerstandselemente auf. Folglich sind die einzelnen Abgriffe und Widerstandselemente abwechselnd zueinander in Reihe geschaltet.

Der Spannungsteiler ist zwischen den ersten Anschluss und einen der Steuereingänge geschaltet. Mit anderen Worten sind die Enden des Spannungsteilers einmal gegen den ersten Anschluss und das andere Mal gegen den Steuereingang eines der Schaltelemente geführt. Jeder Abgriff des Spannungsteilers ist gegen jeweils einen der verbleibenden Steuereingängen geführt. Somit ist jeder der Abgriffe jeweils genau einem der Steuereingänge zugeordnet und umgekehrt. Mit anderen Worten ist jeweils einer der Abgriffe jeweils einem der Steuereingänge und umgekehrt zugeordnet.

Aufgrund des Spannungsteilers erfolgt in Abhängigkeit der jeweils zwischen den beiden Anschlüssen anliegenden Überspannung eine Aktivierung der Schaltelemente, wobei die Anzahl der betätigten Schaltelemente zum Wert der Überspannung korrespondiert. Falls diese vergleichsweise groß ist, werden insbesondere zunächst sämtliche Schaltelemente betätigt. Dann, wenn die Überspannung zwischen den beiden Anschlüssen absinkt, wird aufgrund des Spannungsteilers dasjenige Schaltelement, das mit dem Ende des Spannungsteilers verbunden ist, und nicht mit einem der Abgriffe, betätigt und folglich geöffnet. Falls die elektrische Spannung weiter absinkt, wird dasjenige Schaltelement, das dem ersten Abgriff nach dem Ende des Spannungsteilers zugeordnet ist, abgeschaltet und so weiter. Hierbei ist aufgrund der Widerstandselemente sichergestellt, dass stets eine sukzessive Betätigung der einzelnen Schaltelemente erfolgt, auch falls die einzelnen Widerstandselemente eine vergleichsweise große Fertigungstoleranz aufweisen. Zumindest ist ein gleichzeitiges Betätigen der Schaltelemente auf diese Weise ausgeschlossen. Auch ist vermieden, dass keines der Schaltelemente geschlossen ist, solange zwischen den Anschlüssen eine übermäßige elektrische Spannung anliegt. Somit ist eine Sicherheit erhöht, und bei der Herstellung können vergleichsweise kostengünstige Bauteile herangezogen werden. Zur Betätigung der einzelnen Schaltelemente ist auch keine zusätzliche Schaltung erforderlich oder besondere elektrische und/oder elektronische Bauteile, weswegen Herstellungskosten weiter reduziert sind. Da zudem sämtliche Bauteile im Wesentlichen wartungsfrei sind und lediglich geringen Alterungseffekten unterliegen, sind Betriebskosten reduziert.

Beispielsweise sind sämtliche Widerstände zueinander baugleich, sodass Gleichteile herangezogen werden können. Auf diese Weise sind die Herstellungskosten weiter reduziert. Alternativ hierzu sind die einzelnen Widerstände zueinander unterschiedlich, wobei der Widerstandswert der Widerstände insbesondere mit zunehmendem Abstand des dem jeweiligen zugeordneten Schaltelement zugeordneten Abgriffs des Spannungsteilers von dem ersten Anschluss abnimmt. Somit nimmt sukzessive der Gesamtwiderstand zwischen den beiden Anschlüssen bei zeitlich nachfolgender Betätigung der einzelnen Schaltelemente überproportional zu, sodass die elektrische Spannung vergleichsweise genau eingestellt werden kann.

Vorzugsweise ist die Anzahl der Stränge größer oder gleich 2, 3, 4 oder 5. Somit ist es möglich, für die einzelnen Bauteile der Stränge vergleichsweise kostengünstige Komponenten heranzuziehen, da an jeder aufgrund der Parallelschaltung lediglich eine vergleichsweise geringe elektrische Spannung anliegt. Auch ist ein getragener elektrischer Strom vergleichsweise gering. Ferner ist auf diese Weise eine Baugröße nicht übermäßig erhöht. Alternativ hierzu ist die Anzahl der Stränge größer, sodass die Kosten jedes der Bauteile weiter reduziert werden können. Besonders bevorzugt ist die Anzahl der Stränge kleiner als 20, 18 oder 15. Somit ist eine Baugröße nicht übermäßig erhöht.

Beispielsweise sind die Widerstandselemente zueinander unterschiedliche Bauteile oder besonders bevorzugt zueinander ähnliche Komponenten, wobei sich zum Beispiel die Werte der Komponenten unterscheiden. Zum Beispiel sind die Widerstandselemente oder zumindest eines davon ein ohmscher Widerstand oder ein Kondensator. Besonders bevorzugt jedoch ist eines der Widerstandselemente, vorzugsweise sämtliche Widerstandselemente, eine Zener-Diode. Mit anderen Worten sind die Widerstandselemente Zener-Dioden. Hierbei sind die Widerstandselemente zueinander beispielsweise gleich oder unterscheiden sich anhand der jeweiligen Durchbruchspannung. Da die Widerstandselemente Zener-Dioden, auch als Z-Diode bezeichnet, sind, ist die elektrische Spannung, die zum Schalten des jeweils zugeordneten Schaltelements führt, konstant, auch wenn der zwischen den Anschlüssen über den jeweiligen Strang fließende elektrische Strom unterschiedliche Werte annimmt. Somit sind eine Dimensionierung und Auslegung des Überspannungsschutzes vereinfacht. Auch ist auf diese Weise sichergestellt, dass die Schaltelemente stets bei der jeweils zugeordneten gleichen elektrischen Spannung betätigt werden, die mittels des Spannungsteilers somit eingestellt ist. Die Sperrrichtung der Zener-Dioden ist zweckmäßigerweise in Richtung des ersten Anschlusses gerichtet, sodass lediglich dann, wenn zwischen den beiden Anschlüssen eine bestimmte elektrische Spannung anliegt, die Schaltelemente betätigt sind. Mit anderen Worten ist der Stromfluss von dem ersten Anschluss über den Spannungsteiler unterbunden, sofern die elektrische Spannung geringer als ein bestimmter Wert ist, der anhand der Widerstandselemente vorgegeben ist.

Beispielsweise ist jeder Abgriff direkt mit dem jeweils zugeordneten Steuereingang elektrisch kontaktiert. Besonders bevorzugt jedoch ist zwischen jedem Abgriff und dem jeweils zugeordneten Steuereingang ein weiteres Bauteil angeordnet, beispielsweise eine zweite Diode. Hierbei ist die zweite Diode zweckmäßigerweise derart angeordnet, dass ein elektrischer Stromfluss von dem Steuereingang zu dem Abgriff unterbunden ist. Somit ist eine Rückwirkung der einzelnen Schaltelemente auf andere Schaltelemente unterbunden. Alternativ oder besonders bevorzugt in Kombination hierzu ist zwischen jedem Abgriff und dem jeweiligen Steuereingang ein zweiter Widerstand geschaltet. Der zweite Widerstand ist hierbei insbesondere ein ohmscher Widerstand. Aufgrund des zweiten Widerstands erfolgt ein Schutz des jeweils zugeordneten Schaltelements. Vorzugsweise ist zwischen dem einen der Enden des Spannungsteilers und dem diesem Ende zugeordneten Steuereingang ebenfalls eine zweite Diode und/oder ein zweiter Widerstand geschaltet, sodass auch dieses Schaltelement geschützt ist, bzw. eine Rückwirkung von diesem unterbunden ist.

Beispielsweise ist jeder Steuereingang mit Ausnahme des jeweils zugeordneten Abgriffs mit keinem weiteren Bestandteil des Überspannungsschutzes kontaktiert und somit lediglich gegen den ersten Anschluss - über die jeweils zugeordneten Bauteile - geführt. Besonders bevorzugt jedoch ist jeder Steuereingang oder zumindest einer der Steuereingänge auch gegen den zweiten Anschluss geführt. Hierbei ist zwischen den jeweiligen Steuereingang und den zweiten Anschluss vorzugsweise jeweils ein Bauteil geschaltet, besonders bevorzugt ein weiteres Widerstandselement. Aufgrund des weiteren Widerstandselements wird dabei ein Bezugspotential festgelegt, sodass die an jedem Steuereingang anliegende elektrische Spannung vergleichsweise genau definiert ist, die zum Schalten des jeweiligen Schaltelements führt. Somit ist eine Betriebssicherheit erhöht.

Beispielsweise sind die weiteren Widerstandselemente ohmsche Widerstände. Besonders bevorzugt jedoch sind diese als Zener-Dioden, auch als Z-Diode bezeichnet, ausgeführt. Hierbei ist die Sperrrichtung insbesondere derart, dass ein Stromfluss von dem jeweiligen Steuereingang zu dem zweiten Anschluss unterbunden ist, sofern eine bestimmte elektrische Spannung nicht überschritten ist. Auch ist auf diese Weise ein Schutz des jeweiligen Schaltelements gegen eine übermäßig anliegende elektrische Spannung realisiert. Somit ist eine Betriebssicherheit weiter erhöht. Auch ist somit sichergestellt, dass eine Betätigung der Schaltelemente stets dann erfolgt, wenn zwischen den Anschlüssen die Überspannung anliegt.

Zum Beispiel sind die einzelnen Schaltelemente zueinander unterschiedlich oder mittels unterschiedlicher Arten von Schaltern realisiert. Zum Beispiel ist zumindest eines der oder alle Schaltelemente mittels Relais realisiert. Besonders bevorzugt jedoch sind die Schaltelemente Halbleiterschalter, sodass eine Wartung vereinfacht ist. Auch ist das Ausbilden eines Lichtbogens bei Betätigung vermieden. Da diese zudem lediglich im Überspannungsfall, also lediglich dann, wenn zwischen den beiden Anschlüssen eine Überspannung oder zumindest eine bestimmte elektrische Spannung anliegt, stromführend sind, sind auftretende elektrische Verluste lediglich zeitweise und somit begrenzt. Zum Beispiel sind die Schaltelemente IGBTs, IGCTs oder GTOs. Besonders bevorzugt jedoch sind die Schaltelemente Feldeffekttransistoren und besonders bevorzugt MOSFETs. Diese sind vergleichsweise kostengünstig und in unterschiedlichen Leistungsklassen vorhanden, sodass ein Einsatzbereich des Überspannungsschutzes vergrößert ist. Auch weisen diese jeweils eine Freilaufdiode auf, sodass ein Betrieb des Überspannungsschutzes vereinfacht ist.

Beispielsweise ist der Überspannungsschutz ohne Varistoren ausgestaltet und somit varistorfrei. Somit sind Herstellungskosten reduziert, und auch eine Alterung des Überspannungsschutzes ist im Wesentlichen unterbunden. Alternativ hierzu ist parallel zu einem der Schaltelemente ein Varistor geschaltet. Der Varistor ist dabei insbesondere parallel zu dem Schaltelement geschaltet, dessen Steuereingang lediglich über ein einziges der Widerstandselemente oder zumindest die geringste Anzahl an Widerstandselementen gegen den ersten Anschluss geführt ist. Somit ist der Varistor zu dem Schaltelement parallel geschaltet, das bei Abbau der Überspannung als letztes geöffnet wird. Aufgrund des Varistors wird dabei eine etwaige elektrische Spannung, die aufgrund der Betätigung des Schaltelements verbleibt, abgebaut, sodass der Überspannungsschutz nach Betrieb in einen im Wesentlichen stromlosen Zustand überführt wird. Alternativ oder in Kombination hierzu ist parallel zu diesem Schaltelement, und somit auch zu dem etwaigen Varistor, ein weiterer Kondensator geschaltet, sodass eine Spannungsspitze der aufgrund des Abschaltens des letzten Schaltelements an dem Schaltelement anliegenden elektrischen Spannung vermieden ist. Vorzugsweise ist zu dem weiteren Kondensator/dem Varistor/diesem Schaltelement eine Diode parallel geschaltet, sodass die Ausbildung eines Schwingkreises mittels des etwaigen weiteren Kondensators und des Varistors vermieden ist. Die Diode ist zum Beispiel eine TVS-Diode (Suppressordiode) oder eine Zener-Diode.

**In** einer besonders bevorzugten Ausführungsform ist der Steuereingang jedes Schaltelements über ein jeweiliges weiteres Schaltelement mit dem zweiten Anschluss elektrisch verbunden. Hierbei ist das weitere Schaltelemente derart verschaltet, dass dieses in Abhängigkeit einer über dem jeweils zugeordneten Schaltelement anfallenden elektrischen Spannung betätigt ist. Mit anderen Worten wird das weitere Schaltelement betätigt, wenn die über dem zugeordneten Schaltelement abfallende elektrische Spannung eine bestimmte Bedingung erfüllt, insbesondere einen bestimmten Wert überschreitet. Hierbei wird insbesondere das jeweilige weitere Schaltelement betätigt und geschlossen, wenn die anfallende elektrische Spannung größer als der bestimmte Wert ist. Infolgedessen wird das zugeordnete Schaltelement geöffnet, sodass über dieses ein elektrischer Stromfluss unterbunden ist. Folglich wird insbesondere dann, wenn ein innerer Widerstand des jeweils zugeordneten Schaltelements zunimmt und sich somit erwärmt, dieses im Wesentlichen sofort betätigt, weswegen eine weitere Erwärmung verhindert wird. Somit ist eine Betriebsdauer und auch eine Sicherheit erhöht. Falls das oder die Schaltelemente nämlich als Halbleiterschalter/MOSFET ausgestaltet sind, führt eine sich leicht ändernde, an dem jeweiligen Steuereingang anliegende elektrische Spannung zu einer Erhöhung des inneren Widerstands, wobei dennoch zunächst ein elektrischer Strom fließt.

Geeigneterweise ist jedem der Schaltelemente jeweils ein weiteres Schaltelement zugeordnet. In einer alternativen Ausführung ist lediglich der Steuereingang eines oder eines Teils der Schaltelemente mittels eines jeweiligen weiteren Schaltelements mit dem zweiten Anschluss verbunden. Bei den verbleibenden Schaltelementen ist der jeweilige Steuereingang zweckmäßigerweise von dem jeweiligen zweiten Anschluss getrennt oder lediglich über das jeweilige etwaige weitere Widerstandselement damit verbunden.

Insbesondere ist das weitere Schaltelement ein Feldeffekttransistor. Beispielsweise ist das weitere Schaltelement als MOSFET ausgestaltet. Das weitere Schaltelement ist beispielsweise baugleich zu dem Schaltelement. Besonders bevorzugt jedoch ist das weitere Schaltelement für geringere (elektrische) Spannungen als das jeweilige Schaltelement geeignet, sodass ein kostengünstigeres Bauteil verwendet werden kann. Die Ansteuerung des weiteren Schaltelements erfolgt beispielsweise mittels geeigneter Komponenten.

Besonders bevorzugt weist der Überspannungsschutz ein zusätzliches Schaltelement auf, das einen zusätzlichen Steuereingang umfasst. Hierbei ist das zusätzliche Schaltelement in Abhängigkeit des an dem zusätzlichen Steuereingang anliegenden elektrischen Potentials betätigt. Der weitere Steuereingang ist hierbei insbesondere über das zusätzliche Schaltelement gegen den zweiten Anschluss geführt. Somit ist es möglich, mittels Betätigung des zusätzlichen Schaltelements das weitere Schaltelement und daher das diesem zugeordnete Schaltelement zu betätigen. Hierbei ist eine für die Ansteuerung des zusätzlichen Schaltelements erforderliche elektrische Spannung geringer als für das weitere Schaltelement, weswegen vergleichsweise kostengünstige Bauteile herangezogen werden können. Insbesondere ist das zusätzliche Schaltelement ein Transistor, was Herstellungskosten weiter reduziert.

Der zusätzliche Steuereingang ist insbesondere gegen einen ersten zusätzlichen Widerstand und einen zweiten zusätzlichen Widerstand geführt, die zum Beispiel zueinander elektrisch in Reihe geschaltet sind. Mit anderen Worten sind der erste zusätzliche Widerstand und der zweite zusätzliche Widerstand elektrisch miteinander sowie mit dem zusätzlichen Steuereingang kontaktiert. Die beiden zusätzlichen Widerstände sind zweckmäßigerweise ohmsche Widerstände, weswegen Herstellungskosten reduziert sind. Auch sind auf diese Weise eine Dimensionierung und Auslegung des Überspannungsschutzes vereinfacht.

Mittels der beiden zusätzlichen Widerstände ist insbesondere ein zusätzlicher Spannungsteiler bereitgestellt, mittels dessen das jeweils zugeordnete Schaltelement überbrückt ist. Hierbei ist insbesondere der zweite zusätzliche Widerstand gegen den zweiten Anschluss geführt. Der erste zusätzliche Widerstand ist insbesondere über den Widerstand des hierzu zugeordneten Strangs mit dem ersten Anschluss elektrisch kontaktiert. Zusammenfassend ist somit der zusätzliche Steuereingang über den ersten zusätzlichen Widerstand und den Widerstand des hierzu zugeordneten Strangs gegen den ersten Anschluss und über den zweiten zusätzlichen Widerstand gegen den zweiten Anschluss geführt. Geeigneterweise ist zwischen dem ersten zusätzlichen Widerstand und dem jeweiligen Widerstand eine Diode angeordnet, sodass ein elektrischer Stromfluss lediglich in eine einzige Richtung, zweckmäßigerweise von dem ersten zusätzlichen Widerstand zu dem jeweiligen Widerstand, möglich ist. Folglich sind eine Rückwirkung und ungewollte Effekte vermieden. Zudem erfolgt auch keine Überlastung des zusätzlichen Schaltelements aufgrund der elektrischen Kontaktierung mit dem jeweiligen Strang.

Insbesondere ist der zweite zusätzliche Widerstand mit einem zusätzlichen Kondensator überbrückt. Somit erfolgt ein Verzögertes Einschalten sowie Abschalten des zusätzlichen Schaltelements, weswegen lediglich kurzzeitige übermäßige Spannungen an dem jeweils zugeordneten Schaltelement nicht zu einer Betätigung des zusätzlichen Schaltelements und daher des weiteren Schaltelements und somit des jeweiligen Schaltelements führen. Folglich ist eine Zuverlässigkeit des Überspannungsschutzes erhöht.

**In** einer Variante ist der zusätzliche Steuereingang über den ersten zusätzlichen Widerstand und eines der Widerstandselemente gegen den ersten Anschluss geführt. Beispielsweise sind hierbei zwischen dem Widerstandselement und dem ersten zusätzlichen Widerstandselement keine weiteren Bauteile angeordnet. Besonders bevorzugt jedoch ist zwischen diesen zumindest eine Diode angeordnet, mittels derer ein elektrischer Stromfluss von dem ersten zusätzlichen Widerstand zu dem Widerstandselement unterbunden ist. Alternativ oder in Kombination hierzu ist zwischen dem ersten zusätzlichen Widerstand und dem Widerstandselement ein ohmscher Widerstand angeordnet, sodass eine Reihenschaltung von unterschiedlichen Widerständen erfolgt. Somit ist ein Schutz verbessert. Falls mehrere zusätzliche Schaltelemente vorhanden sind, sind diese vorzugsweise über ein gemeinsames Widerstandselement des Spannungsteilers gegen den ersten Anschluss geführt. Alternativ ist das gemeinsame Widerstandselement kein Bestandteil des Spannungsteilers, und der Spannungsteiler ist über dieses Widerstandselement gegen den ersten Anschluss geführt.

In einer Weiterbildung ist der weitere Steuereingang über eine weitere Zener-Diode gegen den zweiten Anschluss geführt. Somit ist das oder die zusätzlichen Schaltelemente mittels der weiteren Zener-Diode überbrückt, sodass stets eine Ableitung der elektrischen Spannung erfolgt, falls diese größer als die Durchbruchsspannung der weiteren Zener-Diode ist. Folglich wird das zusätzliche Schaltelement mittels der weiteren Zener-Diode geschützt. Auch ist auf diese Weise ein entsprechendes Einschalten des weiteren Schaltelements sichergestellt, sodass dieses entsprechend betätigt wird. Daher ist eine Sicherheit erhöht.

Alternativ oder besonders bevorzugt in Kombination hierzu ist der weitere Steuereingang über eine weitere Diode gegen den ersten Anschluss geführt. Somit ist das am weiteren Steuereingang anliegende elektrische Potential abhängig von dem elektrischen Potential des ersten Anschlusses, sodass gegebenenfalls eine entsprechende Ansteuerung des weiteren Schaltelements erfolgen kann. Vorzugsweise ist hierbei auch der weitere Steuereingang über die weitere Zener-Diode gegen den zweiten Anschluss geführt, sodass die zwischen den Anschlüssen anliegenden elektrische Spannung bei der Ansteuerung des weiteren Schaltelements berücksichtigt wird. Vorzugsweise ist die Sperrrichtung der weiteren Diode entgegengesetzt zur Sperrrichtung der Zener-Diode.

Vorzugsweise ist zwischen der weiteren Diode und dem ersten Anschluss ein zusätzliches Bauteil, beispielsweise eines der Widerstandselemente des Spannungsteilers, geschaltet, sodass nicht in das vollständige an dem ersten Anschluss anliegende elektrische Potential an dem weiteren Steuereingang anliegt, weswegen insbesondere nicht eine gleichzeitige Betätigung des weiteren Schaltelements und des Schaltelements erfolgt. Falls mehrere weitere Schaltelemente vorhanden sind, sind diese vorzugsweise über ein gemeinsames Widerstandselement gegen den ersten Anschluss geführt. Dabei ist das gemeinsame Widerstandselement beispielsweise ein Bestandteil des Spannungsteilers. Alternativ hierzu ist der Spannungsteiler über das gemeinsame Widerstandselement gegen den ersten Anschluss geführt, oder das gemeinsame Widerstandselement ist unabhängig von dem Spannungsteiler.

Besonders bevorzugt ist der weitere Steuereingang über einen weiteren Widerstand gegen den ersten Anschluss geführt. Dabei ist der weitere Widerstand zweckmäßigerweise ein ohmscher Widerstand, was Herstellungskosten reduziert. Vorzugsweise ist der Wert des weiteren Widerstands größer als der Wert des Widerstands des Strangs. Daher erfolgt keine gleichzeitige Betätigung des weiteren Schaltelements und des hierzu zugeordneten Schaltelements. Auch erfolgt mittels des weiteren Widerstands ein Schutz des weiteren Schaltelements. Geeigneterweise ist dabei die weitere Zener-Diode vorhanden, sodass zumindest teilweise ein (weiterer) Spannungsteiler gebildet ist.

Der Überspannungsschutz wird zur Absicherung eines zu schützenden Geräts gegen eine Überspannung und/oder einen Impulsstrom verwendet. Mit anderen Worten dient der Überspannungsschutz der Absicherung des zu schützenden Geräts, insbesondere der elektrischen Absicherung. Vorzugsweise wird mittels des Überspannungsschutzes eine Überspannung an dem zu schützenden Gerät oder ein durch das zu schützende Gerät fließender Impulsstrom vermieden. Die Überspannung/der Impulsstrom entsteht dabei unabhängig von dem Überspannungsschutz und dem zu schützenden Gerät, insbesondere durch ein externes Ereignis, wie einen Blitzschlag. Die Überspannung/der Impulsstrom ist insbesondere derart, dass diese das zu schützenden Gerät beschädigen würde, und mittels des Überspannungsschutzes wird zweckmäßigerweise die an dem zu schützenden Gerät anliegende elektrische Spannung begrenzt. Vorzugsweise fungiert der Überspannungsschutz als Ableiter und ist beispielsweise ein Überspannungs- und/oder Blitzstromableiter.

Das zu schützende Gerät ist beispielsweise ein Schalter oder weist zumindest einen Schalter auf. Beispielsweise ist der Schalter ein Halbleiterschalter, ein Relais oder weist beide auf, die zum Beispiel zueinander parallel geschaltet sind. Somit wird mittels des Überspannungsschutzes eine bei Einschalten des Schalters oder bei Abschalten des Schalters anliegende Überspannung vermieden oder zumindest abgebaut. In einer weiteren Alternative ist das zu schützende Gerät beispielsweise einen Mobilfunkmast oder ein sonstiges elektrisches Gerät.

Der Überspannungsschutz weist dabei einen ersten Anschluss und einen zweiten Anschluss auf, zwischen denen eine Anzahl an Strängen zueinander parallel geschaltet ist, wobei jeder Strang einen Widerstand umfasst, der zwischen den ersten Anschluss und ein einen Steuereingang aufweisendes Schaltelement geschaltet ist. Ferner umfasst der Überspannungsschutz einen Spannungsteiler, der zwischen einen der Steuereingänge und den ersten Anschluss geschaltet ist, und der eine zu der Anzahl an Strängen korrespondierende Anzahl an elektrisch in Reihe geschalteten Widerstandselementen aufweist. Zwischen benachbarten Widerstandselementen ist jeweils ein Abgriff gebildet, wobei jeder Abgriff gegen jeweils einen der verbleibenden Steuereingänge geführt ist.

Das zu schützende Gerät ist zwischen den ersten Anschluss und den zweiten Anschluss geschaltet und somit des Überspannungsschutzes oder zumindest mittels der Stränge überbrückt. Mit anderen Worten sind die Stränge parallel zu dem zu schützenden Gerät geschaltet. Die Erfindung betrifft ferner eine derartige Verschaltung eines zu schützenden Geräts mit einem Überspannungsschutz.

Der Überspannungsschutz wird zum Vorladen eines Hauptkondensators verwendet. Der Überspannungsschutz weist dabei einen ersten Anschluss und einen zweiten Anschluss auf, zwischen denen eine Anzahl an Strängen zueinander parallel geschaltet ist, wobei jeder Strang einen Widerstand umfasst, der zwischen den ersten Anschluss und ein einen Steuereingang aufweisendes Schaltelement geschaltet ist. Ferner umfasst der Überspannungsschutz einen Spannungsteiler, der zwischen einen der Steuereingänge und den ersten Anschluss geschaltet ist, und der eine zu der Anzahl an Strängen korrespondierende Anzahl an elektrisch in Reihe geschalteten Widerstandselementen aufweist. Zwischen benachbarten Widerstandselementen ist jeweils ein Abgriff gebildet, wobei jeder Abgriff gegen jeweils einen der verbleibenden Steuereingänge geführt ist.

Der Hauptkondensator ist elektrisch in Reihe zu den Strängen geschaltet, vorzugsweise zu dem vollständigen Überspannungsschutz. Mit anderen Worten ist einer der Anschlüsse des Hauptkondensators mit dem ersten oder dem zweiten Anschluss elektrisch kontaktiert. Aufgrund des Überspannungsschutzes wird bei Einschalten eines den Hauptkondensator aufweisenden Stromkreises mittels des Überspannungsschutzes eine Vorladung des Hauptkondensators durchgeführt, sodass in dem Stromkreis zunächst ein elektrischer Stromfluss und eine elektrische Spannung begrenzt sind, die aufgrund des Hauptkondensators hervorgerufen werden. Eine unbegrenzte Spannung/Stromfluss würde beispielsweise zur Beschädigung von weiteren Komponenten des Stromkreises führen oder zum Auslösen eines Schutzschalters oder eine Sicherung, mittels derer der Stromkreis abgesichert ist. Aufgrund des Überspannungsschutzes wird ein Auslösen verhindert und die weiteren Komponenten des Stromkreises vor einer Überbelastung geschützt. Der Hauptkondensator ist beispielsweise ein Zwischenkreiskondensator eines Umrichters, und das Vorladen wird beispielsweise vor einer Inbetriebnahme oder zur Inbetriebnahme des Umrichters durchgeführt.

Die Erfindung betrifft ferner eine derartige Verschaltung eines Hauptkondensators mit einem Überspannungsschutz.

Sofern einzelne Bauteile als weiteres, zusätzliches, erstes, zweites, drittes... Bauteil bezeichnet werden, dient dies insbesondere lediglich der Bezeichnung des jeweiligen Bauteils. Insbesondere impliziert dies nicht das Vorhandensein einer bestimmten Anzahl von Bauteilen.

Die im Zusammenhang mit dem Überspannungsschutz und/oder der Schaltung genannten Vorteile und Weiterbildungen sind sinngemäß auch auf die Verwendung sowie die Verschaltungen sowie untereinander zu übertragen und umgekehrt.

Nachfolgend wird ein Ausführungsbeispiel der Erfindung anhand einer Zeichnung näher erläutert. Darin zeigen:
- Fig. 1: schematisch vereinfacht eine Verschaltung mit einem Überspannungsschutz, einem zu schützenden Gerät und einem Hauptkondensator,
- Fig. 2: einen Schaltplan des Überspannungsschutzes,
- Fig. 3: ein Teil des Schaltplans, und
- Fig. 4: einen weiteren Teil des Schaltplans.

Einander entsprechende Teile sind in sämtlichen Figuren mit den gleichen Bezugszeichen versehen.

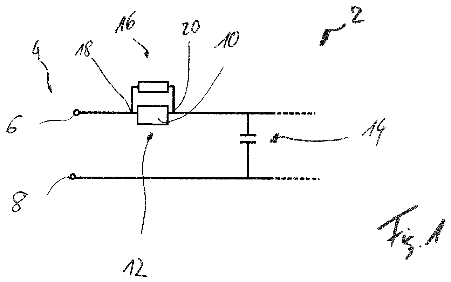

**In** Figur 1 ist schematisch vereinfacht eine Schaltung 2 mit einer Gleichspannungsquelle 4 gezeigt, die einen ersten Pol 6 und einen zweiten Pol 8 aufweist. Der erste Pol 6 ist über einen Schalter 10, der ein zu schützendes Gerät 12 darstellt, mit einem Hauptkondensator 14 verbunden. Der Hauptkondensator 14 ist ein Bestandteil eines nicht näher dargestellten Umrichters und mit dem zweiten Pol 8 der Gleichspannungsquelle 4 verbunden. Folglich ist der Hauptkondensator 14 elektrisch in Reihe mit dem zu schützenden Gerät 12 geschaltet.

Das zu schützende Gerät 12 ist mittels eines Überspannungsschutzes 16 überbrückt, der einen ersten Anschluss 18 und einen zweiten Anschluss 20 aufweist. Hierbei ist das zu schützende Gerät 12 zwischen den ersten Anschluss 18 und den zweiten Anschluss 20 geschaltet. Auch ist der Überspannungsschutz 16 elektrisch in Reihe zu dem Hauptkondensator 14 geschaltet.

Der Überspannungsschutz 16 dient der Absicherung des zu schützenden Geräts 12 vor einer Überspannung. Sofern an dem zu schützenden Gerät 12 eine elektrische Spannung anliegt, die größer als ein bestimmter Wert ist, wird der Überspannungsschutz 16 aktiviert, sodass dieser zumindest teilweise stromführend ist. Infolgedessen wird die zwischen den beiden Anschlüssen 18, 20 anliegende elektrische Spannung begrenzt, und eine Beschädigung des zu schützenden Geräts 12 wird verhindert. Die Überspannung tritt dabei beispielsweise bei Betätigung des Schalters 10 auf, also falls ein elektrischer Stromfluss zwischen dem ersten Pol 6 und dem zweiten Pol 8 unterbrochen werden soll, wobei der Stromfluss aufgrund einer nicht näher dargestellten Induktivität der Verschaltung 2 zumindest teilweise aufrechterhalten wird.

Auch wird der Überspannungsschutz 16 zur Absicherung des zu schützenden Geräts 12 gegen einen Impulsstrom verwendet, also falls in der Verschaltung 2 aufgrund eines Blitzeinschlags oder sonstiger äußerer Einflüsse ein übermäßiger elektrischer Strom auftritt, der nicht von der Gleichstromquelle 4 hervorgerufen wird, und der anderweitig zu einer Zerstörung des zu schützenden Geräts 12, also des Schalters 10, führen würde.

Bei einer weiteren Anwendung wird der Überspannungsschutz 16 zum Vorladen des Hauptkondensators 14 herangezogen. Falls zur Inbetriebnahme, also wenn der Hauptkondensator 14 nicht geladen ist, der Schalter 10 geschlossen wird, wird über diesen ein vergleichsweise großer elektrischer Strom geführt, und es fällt eine vergleichsweise große elektrische Spannung ab. In diesem Fall wird ebenfalls der Überspannungsschutz 16 aktiviert, sodass die an dem zu schützenden Gerät 12, also dem Schalter 10, anliegende elektrische Spannung nicht gleich der zwischen den beiden Polen 6, 8 anliegenden elektrischen Spannung ist. Erst wenn der Hauptkondensator 14 aufgrund des mittels des Überspannungsschutzes 16 verringerten elektrischen Stromflusses zumindest teilweise geladen ist, wird der Überspannungsschutz 16 deaktiviert, sodass dann das restliche Laden des Hauptkondensators 14 über den Schalter 10 erfolgt. Zum Vorladen des Hauptkondensators 14 wird hierbei insbesondere der Schalter 10 nicht geschlossen, sondern der elektrische Strom wird im Wesentlichen lediglich mittels des Überspannungsschutzes 16 geführt.

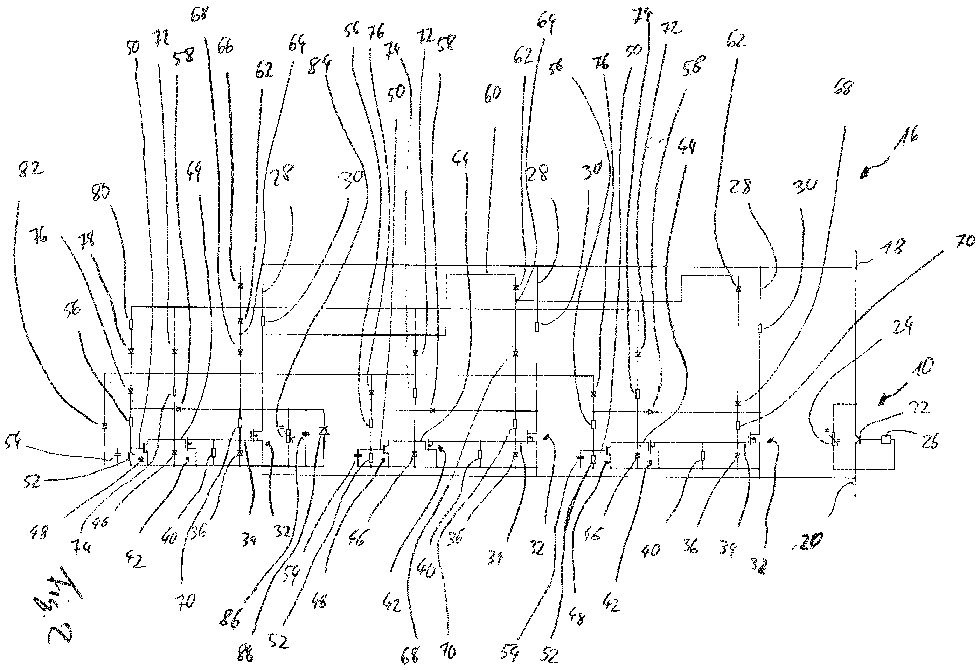

In Figur 2 ist ein Schaltplan des Überspannungsschutzes 16 dargestellt, der den ersten Anschluss 18 und den zweiten Anschluss 20 aufweist. Zwischen diesen ist der Schalter 10 geschaltet, der einen Leitungshalbleiterschalter 22 umfasst. Zur zusätzlichen Absicherung ist ein Hauptvaristor 24 zu dem Leistungshalbleiterschalter 22 parallel geschaltet, der mittels einer Steuerung 26 in Abhängigkeit von aktuellen Anforderungen betätigt wird. Der Hauptvaristor 24 dient hierbei der Bereitstellung von zusätzlicher Sicherheit, falls der Überspannungsschutz 16 fehlerhaft sein sollte.

Der Überspannungsschutz 16 weist eine Anzahl an Strängen 28 auf, die zueinander parallel und zwischen den ersten Anschluss 18 und den zweiten Anschluss 20 geschaltet sind. Somit sind die Stränge 28 auch elektrisch in Reihe zu dem Hauptkondensator 14 geschaltet. Jeder der Stränge 28 weist einen Widerstand 30 auf, der als ohmscher Widerstand ausgebildet ist. Ferner weist jeder Strang 28 ein Schaltelement 32 mit einem Steuereingang 34 auf. Die Schaltelemente 32 sind durchgehend als MOSFET ausgestaltet, und die Widerstände 30 sind ohmsche Widerstände. In einer Alternative werden IGBTs als Schaltelemente 32 verwendet. Jeder Steuereingang 34 ist über jeweils ein weiteres Widerstandselement 36 in Form einer Zener-Diode gegen den zweiten Anschluss 20 geführt. Parallel zu dem weiteren Widerstandselement 36 ist ein zweiter weiterer Widerstand 40 geschaltet, der ein ohmsche Widerstand ist.

Der zweite weitere Widerstand 40 ist jeweils mittels eines weiteren Schaltelements 42 überbrückt, das jeweils einen weiteren Steuereingang 44 aufweist. Jeder weitere Steuereingang 44 ist über eine weitere Zener-Diode 46 gegen den zweiten Anschluss 20 geführt. Dabei ist mittels sowohl der weiteren Widerstandselemente 36 als auch der weiteren Zener-Dioden 46 jeweils ein Stromfluss zu dem zweiten Anschluss 20 lediglich dann möglich, wenn die anliegende elektrische Spannung an dem jeweiligen weiteren Widerstandselement 36 bzw. an der jeweiligen weiteren Zener-Diode 46 größer als die jeweilige Durchbruchspannung ist.

Jede weitere Zener-Diode 46 ist zudem mittels eines zusätzlichen Schaltelements 48 in Form eines Transistors überbrückt, das jeweils einen zusätzlichen Steuereingang 50 aufweist. Der zusätzliche Steuereingang 50 ist über einen zweiten zusätzlichen Widerstand 52 gegen den zweiten Anschluss 20 geführt, wobei der zweite zusätzliche Widerstand 52 mittels eines zusätzlichen Kondensators 54 überbrückt ist.

Ferner ist jeder zusätzliche Steuereingang 50 über einen ersten zusätzlichen Widerstand 56 sowie den Widerstand 30 des dem Schaltelement 32 zugeordneten Strangs 28, der mit dem zugeordneten weiteren Schaltelements 42 sowie dem zusätzlichen Schaltelement 48 verschaltet ist, gegen den ersten Anschluss 18 geführt. Mittels einer zwischen dem ersten zusätzlichen Widerstand 46 und dem jeweiligen Widerstand 30 angeordneten Diode 58 wird dabei ein Stromfluss von dem Strang 28 zu dem zusätzlichen Steuereingang 50 und somit eine Überlastung des jeweiligen zusätzlichen Schaltelements 48 verhindert.

Der Überspannungsschutz 16 weist ferner einen Spannungsteiler 60 auf, der eine zu der Anzahl an Strängen 28 korrespondierende Anzahl an Widerstandselementen 62 aufweist, die elektrisch in Reihe geschaltet sind. Dabei ist die Anzahl der der Widerstandselemente 62 gleich der Anzahl an Strängen 28 und somit gleich drei. Zwischen benachbarten Widerstandselementen 62 sind jeweils Abgriffe 64 gebildet, sodass insgesamt zwei Abgriffe 64 vorhanden sind.

Der Spannungsteiler 60 ist über ein gemeinsames Widerstandselement 66 gegen den ersten Anschluss 18 geführt. Das verbleibende Ende des Spannungsteilers 60 ist über eine zweite Diode 68 und einen zweiten Widerstand 70 gegen den Steuereingang 34 eines der Schaltelemente 32 geführt. Die Abgriffe 64 sind ebenfalls über jeweils eine zweite Diode 68 sowie einen zweiten Widerstand 70 gegen einen der Steuereingänge 34 geführt. Die Widerstandselemente 62 sowie das gemeinsame Widerstandselement 66 sind jeweils als Zener-Dioden ausgebildet. Mittels der Widerstandselemente 62 sowie des gemeinsamen Widerstandselements 66 ist dabei ein Stromfluss von dem ersten Anschluss 18 zu den Steuereingängen 34 unterbunden, sofern die anliegende elektrische Spannung nicht größer als die jeweilige Durchbruchspannung ist. Aufgrund der zweiten Diode 68 wird dabei ein Stromfluss von dem jeweiligen Steuereingang 34 zu dem ersten Anschluss 18 verhindert.

Jeder Steuereingang 34 ist über jeweils eine weitere Diode 72 und einen jeweiligen weiteren Widerstand 74 sowie das gemeinsame Widerstandselement 66 gegen den ersten Anschluss 18 geführt. Mittels der weiteren Dioden 72 wird dabei ein Stromfluss von den weiteren Steuereingängen 44 zu dem ersten Anschluss 18 verhindert.

Jeder zusätzliche Steuereingang 50 ist ferner über jeweils eine erste zusätzliche Diode 76 sowie eine gemeinsame zweite zusätzliche Diode 78, einen gemeinsamen dritten zusätzlichen Widerstand 80 und über das gemeinsame Widerstandselement 66 mit dem ersten Anschluss 18 kontaktiert. Somit sind insgesamt drei erste zusätzliche Dioden 76, jedoch lediglich eine einzige zweite zusätzliche Diode 78 sowie ein einziger dritter zusätzlicher Widerstand 80 vorhanden. Parallel zu den drei Reihenschaltungen aus jeweils einem der zweiten zusätzlichen Widerstände 52, einem der ersten zusätzlichen Widerstände 56 sowie einer der ersten zusätzlichen Dioden 76 ist eine zusätzliche Zener-Diode 82 geschaltet, wobei aufgrund deren Sperrrichtung ein Stromfluss von dem zweiten Anschluss 20 zu dem ersten Anschluss 18 stets möglich ist.

Zu einem der Schaltelemente 32, nämlich dem, dessen Steuereingang 34 über die geringste Anzahl an Widerstandselementen 62 mit dem ersten Anschluss 18 verbunden ist, ist parallel ein Varistor 84 geschaltet, zu dem wiederum parallel ein weiterer Kondensator 86 geschaltet ist. Ferner ist ein zweites Widerstandselement 88 parallel zu dem weiteren Kondensator 86 und somit auch zu dem Varistor 84 geschaltet. Das zweite Widerstandselement 88 ist in dieser Ausführung eine Zener-Diode.

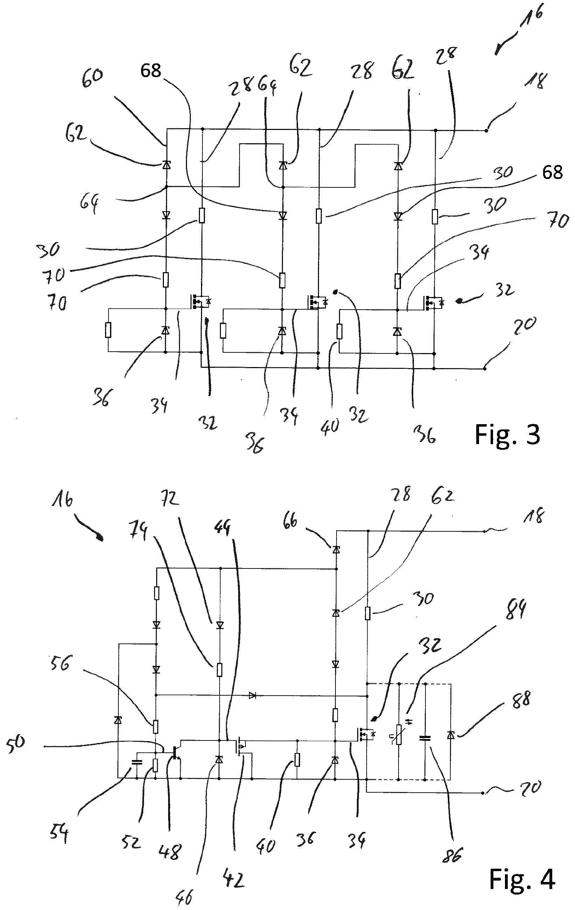

In Figur 3 ist der Überspannungsschutz 16 vereinfacht teilweise dargestellt, um einen Teil der Funktionsweise zu erläutern. Hierbei sind im Wesentlichen lediglich die Stränge 28 sowie der Spannungsteiler 60 mit den Widerstandselementen 62 und den Abgriffen 64 gezeigt. Sofern zwischen den beiden Anschlüssen 18, 20 eine Überspannung oder eine sonstige übermäßige elektrische Spannung auftritt, fällt jeweils eine sukzessive verminderte elektrische Spannung an sämtlichen Abgriffen 64 sowie an dem Ende des Spannungsteilers 60 ab. Infolgedessen werden die Steuereingänge 34 der Schaltelemente mit einem elektrischen Potential versehen, sodass die Schaltelemente 32 in den elektrisch leitenden Zustand versetzt werden. Infolgedessen sind sämtliche Stränge 28 elektrisch leitfähig, weswegen ein elektrischer Stromfluss zwischen den Anschlüssen 18, 20 über die Stränge 28 möglich ist, sodass die elektrische Spannung zwischen den Anschlüssen 18, 20 reduziert wird. Hierbei wird mittels der Widerstände 30 elektrische Energie umgesetzt, weswegen die elektrische Spannung weiter reduziert wird.

Wenn die an den Anschlüssen 18, 20 anliegende elektrische Spannung einen bestimmten Wert unterschritten hat, ist die das von dem ersten Anschluss 18 am weitesten beabstandeten Widerstandselement 62 des Spannungsteilers 60 abfallende elektrische Spannung geringer als dessen Durchbruchspannung. Infolgedessen wird das gegen das Ende des Spannungsteilers 60 geführte Schaltelement 32 in den elektrisch nichtleitenden Zustand versetzt, weswegen dieser Strang 28 nicht mehr leitend ist. Bei einem weiteren Absinken der zwischen den Anschlüssen 18, 20 anliegenden elektrischen Spannung ist die über das zwischen den beiden Abgriffen 64 angeordnete Widerstandselement 62 abfallende elektrische Spannung geringer als dessen Durchbruchspannung, weswegen ein weiterer Strang 28 nicht mehr leitend ist. Somit wird sukzessive aufgrund der Widerstände 30 die zwischen den Anschlüssen 18, 20 anliegende elektrische Spannung abgebaut, wobei auch der elektrische Stromfluss reduziert wird.

Der Spannungsteiler 60 und jedes der weiteren Widerstandselemente 36 wirkt bei jedem der Schaltelemente 32 als jeweiliger Spannungsteiler. Da die Widerstandselemente 62 dabei Zener-Dioden sind, erfolgt ein Betätigen der Schaltelemente 32 bei im Wesentlichen stets der gleichen anfallenden elektrischen Spannung, unabhängig von dem jeweiligen elektrischen Strom. Mittels der zweiten Dioden 68 wird dabei sichergestellt, dass eine Rückwirkung zwischen den einzelnen Strängen 28 unterbunden ist. Mittels der zweiten Widerstände 70 erfolgt ein Schutz der Schaltelemente 32.

In Figur 4 ist ein weiterer Teil des Überspannungsschutzes 16 vereinfacht gezeigt, um einen weiteren Teil der Funktionsweise zu erläutern. Zum Versetzen jeder der Schaltelemente 32 in den elektrisch nicht leitenden Zustand erfolgt eine Änderung des an dem jeweiligen Steuereingang 34 anliegenden elektrischen Potentials, wobei dieses über das zugeordnete weitere Widerstandselement 36 sowie den zweiten weiteren Widerstand 40 auf das elektrische Potential des zweiten Anschlusses sukzessive gebracht wird. Infolgedessen nimmt der innere Widerstand des Schaltelements 32 zu, sodass über das Schaltelement 32 eine vergrößerte elektrische Spannung anfällt, wobei noch ein elektrischer Stromfluss vorhanden ist. Somit steigt die mittels des Schaltelements 32 umgesetzte Energie, und es erfolgt eine Erwärmung, die zu einer Beschädigung führen kann.

Aufgrund der beiden diesem Schaltelement 32 zugeordneten zusätzlichen Widerstände 52, 56 liegt, wenn über das Schaltelement 32 eine vergleichsweise große elektrische Spannung anfällt, an dem zugeordneten zusätzlichen Steuereingang 50 eine elektrische Spannung an, weswegen das zugeordnete zusätzliche Schaltelement 48 betätigt und in den elektrisch leitenden Zustand überführt wird. Da dieses zusätzliche Schaltelement 48 elektrisch leitend ist, wird das an dem zugeordneten weiteren Steuereingang 44 anliegende elektrische Potential auf das elektrische Potential des zweiten Anschlusses 40 geschaltet, sodass dieses weitere Schaltelement 42 elektrisch leitend ist. Infolgedessen wird an dem Steuereingang 34 des Schaltelements 32 im Wesentlichen schlagartig das elektrische Potential des zweiten Anschlusses 20 angelegt, und dieses wird somit schlagartig in den elektrisch nichtleitenden Zustand versetzt. Infolgedessen erfolgt keine weitere Erwärmung des Schaltelements 32, und, sofern noch weitere Stränge 28 vorhanden sind, wird mittels dieser ein Stromfluss zwischen den beiden Anschlüssen 18, 20 übernommen.

Aufgrund der weiteren Zener-Diode 46 ist dabei sichergestellt, dass das weitere Schaltelement 42 lediglich dann in den elektrisch leitfähigen Zustand versetzt wird, wenn eine Betätigung des zusätzlichen Schaltelements 48 erfolgt. Hierbei erfolgt mittels des weiteren Widerstands 74 ein Schutz des weiteren Schaltelements 42, mittels der weiteren Diode 72 ist eine ungewollte Rückwirkung vermieden. Mittels des Widerstandselements 66 ist dabei sichergestellt, dass das zusätzliche Schaltelement 48 sich im elektrisch nichtleitenden Zustand befindet, falls über das Schaltelement 32 keine ausreichende elektrische Spannung anfällt.

Zusammenfassend erfolgt somit ein Betätigen des zusätzlichen Schaltelements 48 und daher auch des weiteren Schaltelements 42 in Abhängigkeit der über dem jeweils zugeordneten Schaltelement 32 anfallenden elektrischen Spannung. Aufgrund des zusätzlichen Kondensators 54 erfolgt hierbei ein verzögertes Einschalten des zusätzlichen Schaltelements 48, sodass kurzzeitige Spannungsspitzen nicht zu einem vorzeitigen Abschalten des Schaltelements 32 führen.

Sofern sämtliche Stränge 28 in dem elektrisch nicht leitfähigen Zustand sind, wird eine verbleibenden elektrische Potentialdifferenz zwischen den beiden Anschlüssen 18, 20 mittels des Varistors 84 umgesetzt, wobei mittels des weiteren Kondensators 86 und des zweiten Widerstandselements 88 sichergestellt wird, dass ein vollständiger Abbau der elektrischen Energie erfolgt.

### Bezugszeichenliste

- 2: Verschaltung
- 4: Gleichspannungsquelle
- 6: erster Pol
- 8: zweiter Pol
- 10: Schalter
- 12: zu schützendes Gerät
- 14: Hauptkondensator
- 16: Überspannungsschutz
- 18: erster Anschluss
- 20: zweiter Anschluss
- 22: Leistungshalbleiterschalter
- 24: Hauptvaristor
- 26: Steuerung
- 28: Strang
- 30: Widerstand
- 32: Schaltelement
- 34: Steuereingang
- 36: weiteres Widerstandselement
- 40: zweiter weiterer Widerstand
- 42: weiteres Schaltelement
- 44: weiterer Steuereingang
- 46: weitere Zener-Diode
- 48: zusätzliches Schaltelement
- 50: zusätzlicher Steuereingang
- 52: zweiter zusätzlicher Widerstand
- 54: zusätzlicher Kondensator
- 56: erster zusätzlicher Widerstand
- 58: Diode
- 60: Spannungsteiler
- 62: Widerstandselement
- 64: Abgriff
- 66: gemeinsames Widerstandselement
- 68: zweite Diode
- 70: zweiter Widerstand
- 72: weitere Diode
- 74: weiterer Widerstand
- 76: erste zusätzliche Diode
- 78: zweite zusätzliche Diode
- 80: dritter zusätzlicher Widerstand
- 82: zusätzliche Zener-Diode
- 84: Varistor
- 86: weiterer Kondensator
- 88: zweites Widerstandselement

## Patentansprüche

1. Überspannungsschutz (16) mit einem ersten Anschluss (18) und mit einem zweiten Anschluss (20), der der Vermeidung einer elektrischen Überspannung zwischen dem ersten Anschluss (18) und dem zweiten Anschluss (20) dient, wobei die Überspannung eine Gleichspannung ist, wobei zwischen den ersten Anschluss (18) und den zweiten Anschluss (20) eine Anzahl an Strängen (28) zueinander parallel geschaltet ist, wobei jeder Strang (28) einen Widerstand (30) aufweist, der zwischen den ersten Anschluss (18) und ein einen Steuereingang (34) aufweisendes Schaltelement (32) geschaltet ist, und mit einem Spannungsteiler (60), der zwischen einen der Steuereingänge (34) und den ersten Anschluss (18) geschaltet ist, und der eine zu der Anzahl an Strängen (28) korrespondierende Anzahl an elektrisch in Reihe geschalteten Widerstandselementen (62) aufweist, wobei zwischen benachbarten Widerstandselementen (62) jeweils ein Abgriff (64) gebildet ist, und wobei jeder Abgriff (64) gegen jeweils einen der verbleibenden Steuereingänge (34) geführt ist, wobei der Überspannungsschutz (16) derart ausgestaltet ist, dass aufgrund des Spannungsteilers (60) in Abhängigkeit einer zwischen den beiden Anschlüssen (18, 20) anliegenden Überspannung eine Aktivierung der Schaltelemente (32) erfolgt, wobei die Anzahl der betätigten Schaltelemente (32) zum Wert der Überspannung korrespondiert, und dass, wenn die Überspannung zwischen den beiden Anschlüssen (18, 20) absinkt, aufgrund der Widerstandselemente (62) sichergestellt, dass eine sukzessive Betätigung der einzelnen Schaltelemente (32) erfolgt.

2. Überspannungsschutz (16) nach Anspruch 1,
**dadurch gekennzeichnet,**
**dass** zwischen jedem Abgriff (64) und dem zugeordneten Steuereingang (34) eine zweite Diode (68) und/oder ein zweiter Widerstand (70) geschaltet ist.

3. Überspannungsschutz (16) nach einem der Ansprüche 1 bis 2,
**dadurch gekennzeichnet,**
**dass** zwischen jeden Steuereingang (34) und den zweiten Anschluss (20) jeweils ein weiteres Widerstandselement (36) geschaltet ist.

4. Überspannungsschutz (16) nach einem der Ansprüche 1 bis 3,
**dadurch gekennzeichnet,**
**dass** die Schaltelemente (32) MOSFETs sind.

5. Überspannungsschutz (16) nach einem der Ansprüche 1 bis 4,
**dadurch gekennzeichnet,**
**dass** parallel zu einem der Schaltelemente (32) ein Varistor (84) geschaltet ist.

6. Überspannungsschutz (16) nach einem der Ansprüche 1 bis 5,
**dadurch gekennzeichnet,**
**dass** der Steuereingang (34) jedes Schaltelements (32) über ein weiteres Schaltelement (42) mit dem zweiten Anschluss (20) elektrisch verbunden ist, das in Abhängigkeit einer über dem jeweils zugeordneten Schaltelement (32) anfallenden elektrischen Spannung betätigt ist.

7. Verwendung eines Überspannungsschutzes (16) nach einem der Ansprüche 1 bis 6 zur Absicherung eines zu schützenden Geräts (12) gegen eine Überspannung und/oder einen Impulsstrom, das zwischen den ersten Anschluss (18) und den zweiten Anschluss (20) geschaltet ist.

8. Verwendung eines Überspannungsschutzes (16) nach einem der Ansprüche 1 bis 6 zum Vorladen eines Hauptkondensators (14), der elektrisch in Reihe zu den Strängen (28) geschaltet ist.

## Claims

1. Surge protection element (16) having a first terminal (18) and having a second terminal (20) and used to prevent an electrical surge voltage between the first terminal (18) and the second terminal (20), wherein the surge voltage is a DC voltage, wherein a number of strands (28) are connected in parallel to each other between the first terminal (18) and the second terminal (20), wherein each strand (28) has a resistor (30) connected between the first terminal (18) and a switching element (32) having a control input (34), and having a voltage divider (60) connected between one of the control inputs (34) and the first terminal (18), and which has a number of resistor elements (62) electrically connected in series, said number of resistor elements corresponding to the number of strands (28), wherein a tap (64) is formed in each case between adjacent resistor elements (62), and wherein each tap (64) is routed to in each case one of the remaining control inputs (34), wherein the surge protection element (16) is designed in such a way that, due to the voltage divider (60), the switching elements (32) are activated depending on a surge voltage present between the two terminals (18, 20), wherein the number of actuated switching elements (32) corresponds to the value of the surge voltage, and that, if the surge voltage between the two terminals (18, 20) decreases, the resistor elements (62) ensure that the individual switching elements (32) are actuated gradually.

2. Surge protection element (16) according to Claim 1,
**characterized**
**in that** a second diode (68) and/or a second resistor (70) is connected between each tap (64) and the assigned control input (34).

3. Surge protection element (16) according to one of Claims 1 to 2,
**characterized**
**in that** a respective additional resistor element (36) is connected between each control input (34) and the second terminal (20).

4. Surge protection element (16) according to one of Claims 1 to 3,
**characterized**
**in that** the switching elements (32) are MOSFETs.

5. Surge protection element (16) according to one of Claims 1 to 4,
**characterized**
**in that** a varistor (84) is connected in parallel with one of the switching elements (32).

6. Surge protection element (16) according to one of Claims 1 to 5,
**characterized**
**in that** the control input (34) of each switching element (32) is electrically connected via an additional switching element (42) to the second terminal (20), which additional switching element is actuated depending on an electrical voltage dropping across the respectively assigned switching element (32).

7. Use of a surge protection element (16) according to one of Claims 1 to 6 for protecting a device (12) which is to be protected against a surge voltage and/or a pulse current and which is connected between the first terminal (18) and the second terminal (20).

8. Use of a surge protection element (16) according to one of Claims 1 to 6 for precharging a main capacitor (14) electrically connected in series with the strands (28).

## Revendications

1. Dispositif de protection contre les surtensions (16) comportant une première borne (18) et une deuxième borne (20), qui sert à éviter une surtension électrique entre la première borne (18) et la deuxième borne (20), la surtension étant une tension continue, dans lequel, entre la première borne (18) et la deuxième borne (20), un certain nombre de branches (28) sont connectées les unes aux autres en parallèle, chaque branche (28) comportant une résistance (30) qui est connectée entre la première borne (18) et un élément de commutation (32) comportant une entrée de commande (34), et comportant un diviseur de tension (60) qui est connecté entre l'une des entrées de commande (34) et la première borne (18), et qui comporte un nombre d'éléments résistifs (62) connectés électriquement en série qui correspond au nombre de branches (28), une prise (64) étant formée respectivement entre des éléments résistifs (62) voisins, et chaque prise (64) étant acheminée respectivement vers l'une des entrées de commande restantes (34), le dispositif de protection contre les surtensions (16) étant configuré de telle sorte que, sur la base du diviseur de tension (60), une activation des éléments de commutation (32) s'effectue en fonction d'une surtension présente entre les deux bornes (18, 20), le nombre d'éléments de commutation (32) actionnés correspondant à la valeur de la surtension, et que, lorsque la surtension entre les deux bornes (18, 20) diminue, il est assuré, en raison des éléments résistifs (62), qu'un actionnement successif des différents éléments de commutation (32) s'effectue.

2. Dispositif de protection contre les surtensions (16) selon la revendication 1,
**caractérisé**
**en ce qu'**une deuxième diode (68) et/ou une deuxième résistance (64) est connectée entre chaque prise (70) et l'entrée de commande (34) associée.

3. Dispositif de protection contre les surtensions (16) selon l'une quelconque des revendications 1 à 2,
**caractérisé**
**en ce qu'**un autre élément de résistance (36) est connecté entre chaque entrée de commande (34) et la deuxième borne (20).

4. Dispositif de protection contre les surtensions (16) selon l'une quelconque des revendications 1 à 3,
**caractérisé**
**en ce que** les éléments de commutation (32) sont des MOSFET.

5. Dispositif de protection contre les surtensions (16) selon l'une quelconque des revendications 1 à 4,
**caractérisé**
**en ce qu'**une varistance (84) est connectée en parallèle avec l'un des éléments de commutation (32).

6. Dispositif de protection contre les surtensions (16) selon l'une quelconque des revendications 1 à 5,
**caractérisé**
**en ce que** l'entrée de commande (34) de chaque élément de commutation (32) est reliée électriquement à la deuxième borne (20) par l'intermédiaire d'un autre élément de commutation (42), lequel est actionné en fonction d'une tension électrique apparaissant aux bornes de l'élément de commutation (32) respectivement associé.

7. Utilisation d'un dispositif de protection contre les surtensions (16) selon l'une quelconque des revendications 1 à 6 pour protéger un appareil (12) à protéger contre une surtension et/ou un courant pulsé, lequel est connecté entre la première borne (18) et la deuxième borne (20).

8. Utilisation d'un dispositif de protection contre les surtensions (16) selon l'une quelconque des revendications 1 à 6 pour la précharge d'un condensateur principal (14) qui est connecté électriquement en série avec les branches (28).
